# EUROPEAN PATENT APPLICATION

(11) **EP 4 765 175 A1**
(43) Date of publication of application: **24.06.2026**
(21) Application number: 25210665.3
(22) Date of filing: 23.10.2025
(51) Int. Cl.: H01F 30/02, H02H 1/00, H02H 3/08, H02J 3/1878, H02J 3/26, H02J 3/38

(54) **METHOD AND APPARATUS FOR PREDICTING CURRENT OF LOAD IN AUTOTRANSFORMER**

(30) Priority: 23.12.2024 KR 20240194606
(71) Applicant: Hanwha Solutions Corporation, Jung-gu Seoul 04541 (KR)
(72) Inventor: LEE, Ji Cheol, 04541 Seoul (KR); HONG, Seok Yong, 04541 Seoul (KR); KIM, Se Jin, 04541 Seoul (KR); PARK, Sang Yong, 04541 Seoul (KR)
(74) Representative: Mooser, Sebastian Thomas

(57) **Abstract**

Provided are a method and apparatus for predicting a current of a load (550) in an autotransformer (540). A processor is configured to obtain a value of a current of a first input terminal (520) and a value of a current of a first stage of an autotransformer (530), predict whether a plurality of loads are unbalanced, based on the value of the current of the first input terminal (520), the value of the current of the first stage (530), and a characteristic of the autotransformer (540), and determine whether to open a relay (510), based on a result of the prediction and a current flowing through the autotransformer (540), wherein a turn ratio of the autotransformer (540) is 1.

## Description

### BACKGROUND

### 1. Field

The disclosure relates to a method and apparatus for predicting a current of a load in an autotransformer.

### 2. Description of the Related Art

In the related art, an autotransformer located in a distribution panel controls a current of a load through a method by which a controller measures a voltage of the load and adjusts a variable tap of the autotransformer. More specifically, the controller of the autotransformer of the related art adjusts the variable tap downward when the voltage of the load is lower than a threshold voltage, and adjusts the variable tap upward when the voltage of the load is higher than the threshold voltage.

Such existing autotransformers require a separate controller to maintain the threshold voltage, and has structural complexity due to installation of the variable tap.

In addition, when the variable tap is controlled through the controller, voltage stabilization response is relatively slow when the voltage of the load changes rapidly.

Accordingly, there is a need for a more efficient method and apparatus for controlling the voltage of the load or predicting the current of the load in the autotransformer.

The aforementioned background technology is technical information possessed by the inventor for derivation of the disclosure or acquired by the inventor during the derivation of the disclosure, and is not necessarily prior art disclosed to the public before the application of the disclosure.

### SUMMARY

Provided are a method and apparatus for predicting a current of a load in an autotransformer. Aspects of the disclosure are not limited to those mentioned above, and other aspects and advantages of the disclosure, which are not mentioned, will be understood from descriptions below and will become more apparent by embodiments of the disclosure. In addition, the aspects and advantages of the disclosure will be realized through means and combinations thereof in the claims.

According to an embodiment of the disclosure, a method of predicting a current of a load in an autotransformer, includes obtaining a value of a current of a first input terminal and a value of a current of a first stage of the autotransformer, predicting whether a plurality of loads are unbalanced, based on the value of the current of the first input terminal, the value of the current of the first stage, and a characteristic of the autotransformer, and determining whether to open a relay, based on a result of the prediction and a current flowing through the autotransformer, wherein a turn ratio of the autotransformer is 1.

According to another embodiment of the disclosure, a processor is configured to obtain a value of a current of a first input terminal and a value of a current of a first stage of an autotransformer, predict whether a plurality of loads are unbalanced, based on the value of the current of the first input terminal, the value of the current of the first stage, and a characteristic of the autotransformer, and determine whether to open a relay, based on a result of the prediction and a current flowing through the autotransformer, wherein a turn ratio of the autotransformer is 1.

According to another embodiment of the disclosure, a distribution device of a solar power generation system includes the above processor.

According to another embodiment of the disclosure, a computer-readable recording medium has recorded thereon a program for executing the above method on a computer.

### BRIEF DESCRIPTION OF THE DRAWINGS

Embodiments of the disclosure will be described with reference to the accompanying drawings described below, in which like reference numerals refer to similar elements, but are not limited thereto:
FIG. 1 is a diagram for schematically describing a power supply system;
FIG. 2 illustrates an example of a power supply system according to an embodiment;
FIG. 3 is a diagram of a power supply structure of a building in which a photovoltaic module is installed, according to an embodiment;
FIG. 4 is a block diagram of a distribution device including an apparatus for predicting a current of a load in an autotransformer, according to an embodiment;
FIG. 5 is a diagram for describing an overall circuit used in an apparatus for predicting a current of a load in an autotransformer, according to an embodiment;
FIG. 6 is a diagram for describing current and voltage waveforms in an unbalanced current, according to an embodiment;
FIG. 7 is a diagram for describing a process of predicting a current of a load in an unbalanced current, according to an embodiment;
FIG. 8 is a diagram for describing current and voltage waveforms in a balanced current, according to an embodiment;
FIG. 9 is a diagram for describing a process of predicting a current of a load in a balanced current, according to an embodiment;
FIG. 10 is a flowchart of a method of predicting a current of a load in an autotransformer, according to an embodiment; and
FIG. 11 is a flowchart for describing a process of predicting imbalance when an unbalanced current flows in a load, according to an embodiment.

### DETAILED DESCRIPTION

Advantages and features of the disclosure and methods of accomplishing the same may be understood more readily by reference to the following detailed description of the embodiments and the accompanying drawings. However, it should be understood that the disclosure is not limited to the embodiments presented below, but may be implemented in various different forms, and include all transformations, equivalents, and substitutes included in the scope of the disclosure. The embodiments presented below are provided to complete the disclosure and to fully inform one of ordinary skill in the art of the scope of the disclosure. In the description of the disclosure, certain detailed explanations of related art are omitted when it is deemed that they may unnecessarily obscure the essence of the disclosure.

Also, the terms used in the present specification are only used to describe specific embodiments, and are not intended to limit the disclosure. Unless otherwise defined, all terms used in the present specification have the same meanings as commonly understood by one of ordinary skill in the art.

In the specification, an expression used in the singular encompasses the expression of the plural, unless it has a clearly different meaning in the context. Also, it is to be understood that terms such as "including" or "having", etc., are intended to indicate the existence of the features, numbers, steps, actions, components, parts, or combinations thereof disclosed in the specification, and are not intended to preclude the possibility that one or more other features, numbers, steps, actions, components, parts, or combinations thereof may exist or may be added.

Further, the terms including ordinal numbers such as "first", "second", and the like used in the present specification may be used to describe various components, but the components should not be limited by the terms. The above terms are used only to distinguish one element from another.

The phrase such as "in an embodiment," "according to an embodiment," "related to an embodiment," or "according to an implementation of an embodiment" in the present specification does not necessarily all refer to the same embodiment. In addition, throughout the specification, an "embodiment" is an arbitrary classification for easily describing the disclosure, and embodiments do not need to be mutually exclusive. For example, configurations mentioned for description of an embodiment may be applied and/or implemented in other embodiments, and may be applied and/or implemented with changes without departing from the scope of the disclosure.

Some embodiments of the disclosure may be represented by functional block configurations and various processing operations. Some or all of the functional blocks may be implemented by various numbers of hardware and/or software configurations that perform particular functions. For example, the functional blocks of the disclosure may be implemented by one or more microprocessors or by circuit configurations for a certain function.

For example, the functional blocks of the disclosure may be implemented in various programming or scripting languages. The functional blocks may be implemented by algorithms executed in one or more processors. In addition, the disclosure may employ general techniques for electronic environment setting, signal processing, and/or data processing. Terms such as "mechanism", "element", "means", and "configuration" may be used broadly and are not limited as mechanical and physical configurations. In addition, terms such as "unit", "-er/or", and "module" denote a unit that processes at least one function or operation, which may be implemented in hardware or software, or implemented in a combination of hardware and software.

In addition, a connection line or a connection member between components shown in drawings is merely a functional connection and/or a physical or circuit connection. In an actual device, connections between components may be represented by various functional connections, physical connections, or circuit connections that are replaceable or added.

Also, some components in the drawings may be somewhat exaggerated in sizes or proportions. In addition, components shown in one drawing may not be shown in other drawings.

The term "autotransformer" may refer to a transformer in which a primary winding and a secondary winding are not independent, but a single winding is shared.

Hereinafter, the disclosure will be described in detail with reference to accompanying drawings.

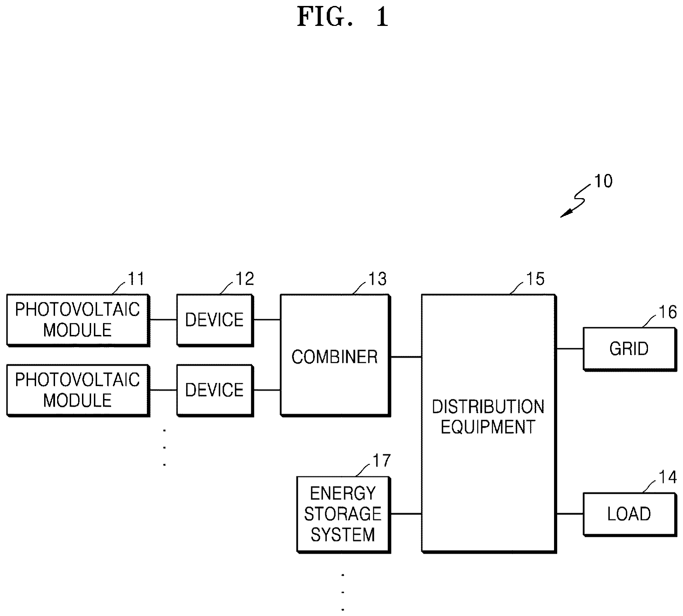

FIG. 1 is a diagram for schematically describing a power supply system 10.

Referring to FIG. 1, the power supply system 10 may include a photovoltaic module 11, a device 12, a load 14, and/or a distribution device 15. The power supply system 10 may be connected to an external grid 16.

At least one photovoltaic module 11 may be installed on a roof or exterior wall of a building and generate power. A plurality of photovoltaic modules 11 may be connected to each other to form a photovoltaics module array.

The photovoltaic module 11 may be connected to the device 12. For example, at least one device 12 may be connected to each photovoltaic module 11. For example, when one device 12 is connected to each photovoltaic module 11, the number of devices 12 configuring the power supply system 10 may be the same as the number of photovoltaic modules 11.

The device 12 may include a power conditioning system (PCS) or power conversion system, which performs power conversion for power generated in the photovoltaic module 11. For example, the device 12 may perform certain conversion on the power generated in the photovoltaic module 11 and supply the power to other components (e.g., the grid 16 and/or load 14) of the power supply system 10.

The device 12 may include module level power electronics (MLPE). For example, the device 12 may include an optimizer or a micro inverter (MI).

For example, when the device 12 includes an optimizer, the device 12 may adjust power generated in the photovoltaic module 11 and output the adjusted power to an inverter (e.g., a string inverter). A current converted by the inverter (e.g., convert a direct current into an alternating current) may be output to the grid 16 or the load 14.

In another example, when the device 12 is an MI, the device 12 may convert power generated in the photovoltaic module 11 (e.g., convert a direct current into an alternating current). The current converted by the device 12 may be output to the grid 16 or the load 14.

When necessary, the power supply system 10 may further include a combiner 13. At least some of the devices 12 may be connected to the distribution device 15 through the combiner 13. For example, power output from a plurality of devices 12 may be combined into one output in the combiner 13 and supplied to the distribution device 15.

The device 12 and the distribution device 15 may be connected to each other through a power path that does not include the combiner 13, or at least one device 12 may be connected to the distribution device 15 through a power path that does not include the combiner 13 while at least one other device 12 may be connected to the distribution device 15 through the combiner 13.

The combiner 13 may control a voltage, a current, and/or power output from the device 12 according to a power supply status of the photovoltaic module 11, the device 12 and/or the grid 16, and an operating mode of the combiner 13 may be set to a diagnosing mode, a driving mode, or the like.

The combiner 13 may include an energy management system (EMS) configured to control operations of the combiner 13. The EMS may control a voltage, a current, and/or power supplied to the combiner 13 or output from the combiner 13 according to the power supply status of the photovoltaic module 11, the device 12 and/or the grid 16, and the operating mode of the combiner 13 may be set to the diagnosing mode, the driving mode, or the like.

The load 14 refers to an entity that is installed at an electric power consumer, such as a house, a commercial facility, or a factory, and operates by receiving at least one of energy generated by the photovoltaic module 11, energy stored in an energy storage system 17, and/or energy supplied from the grid 16. For example, when the electric power consumer receiving power is a house, the load 14 may include a home appliance, such as a washing machine, a refrigerator, or a television (TV).

The grid 16 may include an infrastructure system for generating, transmitting, and distributing power. For example, a grid 16 may include an infrastructure system such as a power plant, a substation, and a power line. The grid 16 may transfer electrical energy generated in a power plant to the power supply system 10 or transfer surplus power generated in the power supply system 10 to the outside of the power supply system 10.

For example, commercial power transmitted from the grid 16 through a telegraph pole may be supplied to a power consumer through a transformer. The power supply system 10 may be implemented as an off-grid system that is not connected to the grid 16.

The power supply system 10 may further include at least one energy storage system 17. When necessary, the power supply system 10 may include a plurality of energy storage systems 17. The energy storage system 17 may receive and store power generated by the photovoltaic module 11 and/or power transmitted from the grid 16. The energy storage system 17 may efficiently supply power by storing power and supplying power to the load 14 when the load 14 needs power.

The energy storage system 17 may include a battery storing power, and a power conversion module. The battery may include a battery management system (BMS) configured to monitor a state of charge (SOC), a state of health (SOH), a voltage and/or a current of the battery, perform diagnosis on the battery, and perform a safety function such as current cutoff.

The power conversion module may be a PCS configured to perform conversion between power at the battery and power at an opposite side. For example, the PCS may convert between a direct current at the battery and an alternating current at an opposite side. For example, the PCS may include a bidirectional direct current (DC)-DC converter that is connected to the battery and converts a voltage, and a bidirectional inverter that connects a DC-DC converter and the outside of the energy storage system 17.

The energy storage system 17 may further include an EMS configured to control operations of the energy storage system 17. The EMS may control a voltage, a current and/or power supplied to or output from the energy storage system 17 according to a power supply status of the battery and/or grid 16, and may set an operating mode of the energy storage system 17 to a diagnosing mode, a driving mode, or the like.

When necessary, the EMS coupled to a certain component of the power supply system 10 may not only control operations of the certain component, but may also further control operations of other components of the power supply system 10. For example, the EMS coupled to the combiner 13 or the EMS coupled to the energy storage system 17 may control both operations of the combiner 13 and operations of the energy storage system 17.

The distribution device 15 may provide an electrical connection between components of the power supply system 10 and may control a power flow of the power supply system 10. For example, the distribution device 15 may electrically connect the photovoltaic module 11 and the load 14 to each other. For example, the distribution device 15 may be connected to the device 12 that is connected to the photovoltaic module 11 to electrically connect the photovoltaic module 11 and the load 14 to each other. When necessary, the distribution device 15 may be further connected to at least one of the energy storage system 17 and the grid 16.

For example, the distribution device 15 may be a distribution panel configured to distribute power within the power supply system 10. For example, the distribution device 15 may be a master service panel (MSP) configured to distribute power generated in the photovoltaic module 11 to the load 14 and the like.

In another example, the distribution device 15 may be a main controller configured to perform power distribution within the power supply system 10 and control each device 12. For example, the main controller may include a switch, a circuit breaker, and a control unit. The switch, the circuit breaker, and the control unit may each be implemented as independent devices, or at least some of the switch, the circuit breaker and the control unit may be included in a single device.

The main controller may include the switch that controls electrical connections between components connected to the main controller, such as the device 12 and the load 14. For example, the main controller may include a relay or a power semiconductor, which provides or blocks an electrical connection to the device 12 and/or the energy storage system 17, depending on an operating status of each component of the power supply system 10.

The main controller may perform rapid shutdown to stop power generation of the photovoltaic module 11 in an emergency situation such as occurrence of an overcurrent in the power supply system 10. In this regard, the main controller may include the circuit breaker configured to block a connection between the device 12 and the load 14.

The main controller may include the control unit configured to generally control operations of the main controller. The control unit may control operations of other components (e.g., the device 12 or the energy storage system 17) of the power supply system 10, in addition to the main controller.

The control unit may control a voltage, a current and/or power output from or supplied to each component, according to a power supply status of the photovoltaic module 11, the device 12, the combiner 13, the load 14, the grid 16 and/or the energy storage system 17. In some embodiments, the control unit may set an operating mode of the main controller, the device 12 and/or the energy storage system 17 to a diagnosing mode, a driving mode, or the like.

For example, the control unit may control the photovoltaic module 11, the device 12, the combiner 13 and/or the energy storage system 17, based on a status of the power supply system 10. For example, the control unit may control other components of the power supply system 10 by causing the main controller to communicate with other components (e.g., the device 12) of the power supply system 10. Communication between the main controller and other components of the power supply system 10 may be performed using power line communication (PLC), but is not limited thereto.

For example, the control unit may control the device 12 according to a power generation status of the photovoltaic module 11. For example, the main controller may receive, from a server, a control command to monitor the power generation status of the photovoltaic module 11, and the control unit may control the device 12 according to the control command.

The main controller may supply power to at least a portion of the load 14 when power supply from the grid 16 is not smooth (e.g., in an off-grid situation). For example, when the power supply from the grid 16 is not smooth, the main controller may preferentially supply power generated in the photovoltaic module 11 and/or power stored in the energy storage system 17 to a backup load that has a relatively high need for stable power supply.

The main controller may include a processor. The processor may predict whether a current flowing through a plurality of loads is unbalanced and may determine to open the relay when a current equal to or greater than a threshold value flows through an autotransformer.

The power supply system 10 may further include an auxiliary power generation device (e.g., a diesel generator) configured to generate power in a separate manner other than solar power generation. For example, the auxiliary power generation device may be further connected to the distribution device 15. When the backup load is unable to be handled by only the photovoltaic module 11 and the energy storage system 17 due to environmental factors such as time zone or weather, the main controller may supply power generated by the auxiliary power generation device to the backup load.

The control unit may be implemented by at least one processor. The processor may process a command of a computer program by performing basic arithmetic, logic, and input/output operations. Here, a command may be provided from an internal memory of the main controller or from an external device. In some embodiments, the processor may generally control operations of other components included in the main controller.

The processor may perform at least some of data analysis, processing, and result information generation for performing the above-described operations by using at least one of machine learning, a neural network, and a deep learning algorithm as a rule-based or artificial intelligence algorithm. Examples of the neural network include architecture-based neural network models, such as a convolutional neural network (CNN), a deep neural network (DNN), and a recurrent neural network (RNN).

For example, the processor may be implemented as an array of a plurality of logic gates, or in a combination of a general-purpose microprocessor and a memory storing a program executable by the general-purpose microprocessor. For example, the processor may include a general-purpose processor, a central processing unit (CPU), a microprocessor, a digital signal processor (DSP), a controller, a microcontroller, a state machine, or the like.

In some environments, the processor may include an application-specific semiconductor (ASIC), a programmable logic device (PLD), a field programmable gate array (FPGA), or the like. For example, the processor may refer to a combination of processing devices, such as a combination of a DSP and a microprocessor, a combination of a plurality of microprocessors, a combination of one or more microprocessors coupled with a DSP core, or a combination of any other such components.

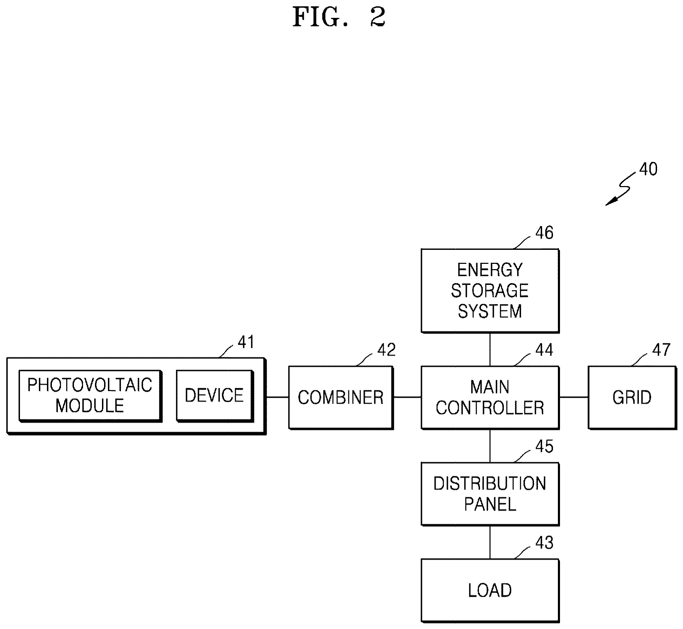

By combining at least some of the components described above, the power supply system 10 may be implemented in various forms. Hereinafter, an embodiment of the power supply system 10 will be described with reference to FIG. 2. However, an implementation method of the power supply system 10 is not limited to the embodiment described below.

FIG. 2 illustrates an example of a power supply system 40 according to an embodiment.

Referring to FIG. 2, the power supply system 40 according to an embodiment may include a solar power generation device 41, a combiner 42, a load 43, a main controller 44, a distribution panel 45, and an energy storage system 46. The power supply system 40 may be connected to an external grid 47.

Meanwhile, the combiner 42, the load 43, and the energy storage system 46 illustrated in FIG. 2 may correspond to a combiner 13, a load 14, and an energy storage system 16 illustrated in FIG. 1, respectively. In some embodiments, the main controller 44 illustrated in FIG. 2 may correspond to the main controller described above with reference to FIG. 1.

The main controller 44 may include a processor configured to predict a current of a load in an autotransformer of the disclosure. In detail, the processor may predict whether a current flowing through a plurality of loads is unbalanced and may determine to open a relay when a current equal to or greater than a threshold value flows through the autotransformer.

The combiner 42 may electrically connect at least one solar power generation device 41 and the main controller 44 to each other. For example, the combiner 42 may combine power output from at least one solar power generation device 41 into one output and supply the same to the main controller 44.

The main controller 44 may electrically connect the combiner 42, the distribution panel 45, and the grid 47 to each other. In addition, the main controller 44 may connect the above-described components to the energy storage system 46 and/or an auxiliary power source such as an auxiliary power generation device (e.g., a diesel generator). For example, the main controller 44 may output power supplied from the combiner 42 to the distribution panel 45, the energy storage system 46, and/or the grid 47. In some embodiments, the main controller 44 may output power supplied from the grid 47 to the distribution panel 45 or the energy storage system 46. In some embodiments, the main controller 44 may output power supplied from the energy storage system 46 to the distribution panel 45.

The distribution panel 45 may electrically connect the main controller 44 and at least one load 43. Accordingly, the power supply system 40 may supply power generated in the solar power generation device 41 to the load 43 through the distribution panel 45.

The power supply system 40 may integrate a plurality of energy storage systems 46 and/or the auxiliary power generation devices into the power supply system 40 by including the main controller 44, thereby stably supplying power. In addition, the power supply system 40 may stably supply power to the load 43 such as a backup load even in an off-grid environment where power is unable to be stably supplied from the grid 47.

The main controller 44 may control a voltage, a current and/or power output from or supplied to each component according to a status of the solar power generation device 41, the load 43, the energy storage system 46, and/or the grid 47, and may set an operating mode of the main controller 44, the solar power generation device 41 and/or the energy storage system 46 to a diagnosing mode, a driving mode, or the like.

In an embodiment, the power supply system 40 may further include a sub-panel (not shown) connected to the main controller 44 and distinguished from the distribution panel 45. At this time, at least one backup load having a relatively high need for stable power supply, from among the loads 43, may be connected to the sub-panel, and at least one non-backup load having a relatively low need for stable power supply, from among the loads 43, may be connected to the distribution panel 45.

The main controller 44 may electrically connect the combiner 42, the distribution panel 45, the energy storage system 46, the grid 47, and the sub-panel to each other. The main controller 44 may supply power supplied from the combiner 42, the energy storage system 46 and/or the grid 47 to at least one non-backup load through the distribution panel 45 and to the backup load through the sub-panel.

In some embodiments, in an embodiment, the power supply system 40 further includes a sub-panel connected to the main controller 44 and distinguished from the distribution panel 45, and the grid 47 may be connected to the distribution panel 45 instead of being connected to the main controller 44. In other words, the main controller 44 may electrically connect the combiner 42, the distribution panel 45, the energy storage system 46, and the sub-panel to each other, and the distribution panel 45 may electrically connect the main controller 44, the non-backup load, and the grid 47 to each other.

For example, the power supply system 40 may be implemented by connecting the main controller 44, which connects the combiner 42 and the energy storage system 46 to each other, to the distribution panel 45 that is pre-installed to connect at least one load 43 and the grid 47 to each other.

Accordingly, the power supply system 40 may stably supply power to the load 43 such as a backup load even in an off-grid environment where power is unable to be stably supplied from the grid 47.

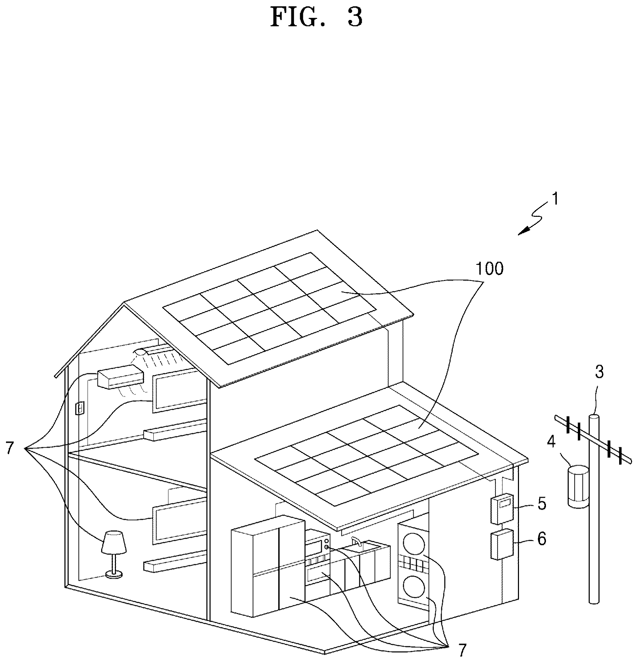

FIG. 3 is a diagram of a power supply structure of a building 1 in which a photovoltaic module 100 is installed, according to an embodiment.

Referring to FIG. 3, a plurality of photovoltaic modules 100 may be installed on a roof of the building 1 and generate energy by using solar energy.

The plurality of photovoltaic modules 100 may be connected to each other to form a photovoltaics module array. The photovoltaics module array is an array of a plurality of photovoltaic modules and may include one output terminal.

The photovoltaic module 100 may include a power conversion device. For example, the power conversion device controls power conversion of the photovoltaic module 100 and may optimize energy generation by including at least one of an optimizer and an MI. The power conversion device may monitor a status of the photovoltaic module 100, determine whether there is a failure, and transmit data to the outside. For example, the power conversion device may be a device that includes a converter (i.e., a device that converts an alternating current to a direct current) and an inverter (i.e., a device that converts a direct current to an alternating current).

A distribution panel 6 may convert power generated in the photovoltaic module 100 and supply the generated power into the building 1. As described above with reference to FIG. 1, the distribution panel 6 may be the distribution device 15 of FIG. 1.

Commercial power transmitted through a telegraph pole 3 may be supplied to the building 1 through a transformer 4.

A plurality of home appliances 7 may operate by selectively receiving at least one of commercial power or power generated by the photovoltaic module 100. A watt-hour meter 5 may measure the amount of power consumed in the building 1.

When a separate energy storage system (ESS) is installed in the building 1, power generated in the photovoltaic module 100 may be stored in the ESS.

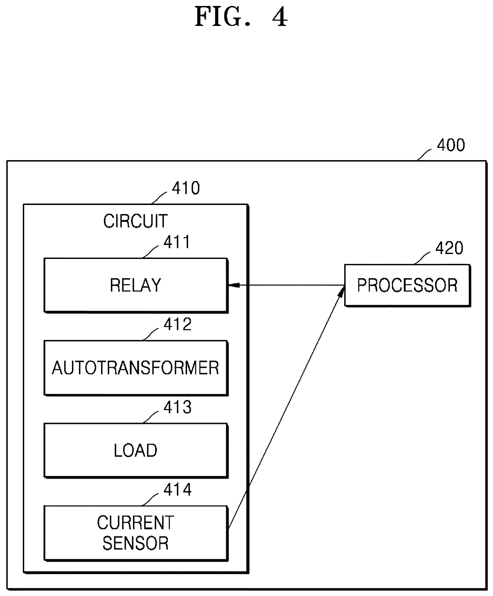

FIG. 4 is a block diagram of a distribution device 400 including an apparatus for predicting a current of a load 413 in an autotransformer 412, according to an embodiment.

Referring to FIG. 4, the distribution device 400 may include a circuit 410 and a processor 420. The circuit 410 may include at least one of a relay 411, the autotransformer 412, the load 413, or a current sensor 414. The processor 420 may be included in the main controller 44 within the distribution device 400.

For convenience of description, only components related to the disclosure are illustrated in FIG. 4. Accordingly, in addition to the components illustrated in FIG. 4, other general-purpose components may be further included in the distribution device 400.

In the disclosure, the load 413 may include a plurality of loads, and the plurality of loads may be the plurality of home appliances 7 of FIG. 3.

In the disclosure, the autotransformer 412 may indicate a transformer including an auxiliary winding connected to a middle point of a series winding. The autotransformer 412 is used to uniformly maintain a voltage at the load 413, regardless of which load 413 is connected to the circuit 410 through the autotransformer 412. The disclosure may be used to open the relay 411 to prevent damage to the load 413 when an unbalanced current flows in the load 413 and a current equal to or greater than a threshold value flows in the load 413, while using the autotransformer 412 in an off-grid situation.

Here, "off-grid" may also be expressed as "standalone power system" or "non-grid situation", and refers to a situation where power is generated and used independently without being connected to a central grid.

According to an embodiment, in the off-grid situation, the processor 420 may predict the current flowing through the load 413 and, when a value of the current flowing through the load 413 is equal to or greater than the threshold value, determine to open the relay 411.

In detail, the processor 420 may obtain a value of a current of the first input terminal and a value of a current of a first stage of the autotransformer 412, measured through the current sensor 414. The processor 420 may predict whether the plurality of loads are unbalanced, based on the obtained values of currents, and determine whether to open the relay 411, based on results of the prediction and a current flowing through the autotransformer 412.

In detail, the processor 420 may predict that the plurality of loads are unbalanced when the values of currents flowing through the plurality of loads are different from each other. At this time, when the value of the current flowing through the autotransformer 412 is equal to or greater than the threshold value, the processor 420 may determine to open the relay 411.

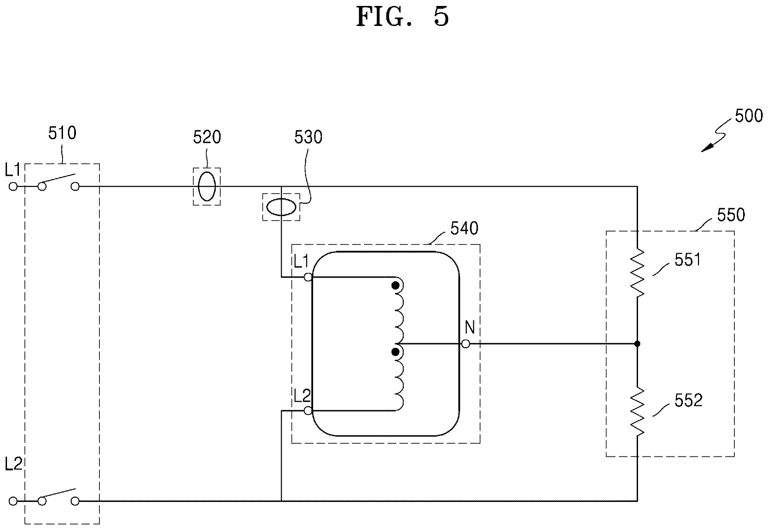

As such, the processor 420 may prevent damage to the load 413 by opening the relay 411 when the values of currents flowing through the plurality of loads are not the same according to the results of prediction and the value of the current flowing through the autotransformer 412 is equal to or greater than the threshold value. A specific process of predicting whether the plurality of loads are unbalanced will be described below with reference to FIGS. 5 to 9.

FIG. 5 is a diagram for describing an overall circuit 500 used in an apparatus for predicting a current of a load in an autotransformer 540, according to an embodiment.

Referring to FIG. 5, the circuit 500 may include a relay 510, a first current sensor 520, a second current sensor 530, the autotransformer 540, a first load 551, and a second load 552. A plurality of loads 550 may include the first load 551 and the second load 552, and the circuit 500 may be included in the distribution device 15 of FIG. 1.

The first current sensor 520 may measure a value of a current of a first input terminal, and the second current sensor 530 may measure a value of a current of a first stage of the autotransformer 540. In some embodiments, the relay 510 is a switching device configured to open or close, or control an electric circuit by using an electric signal, and may be controlled by the processor 420.

For convenience of description, only components related to the disclosure are illustrated in FIG. 5. Accordingly, in addition to the components illustrated in FIG. 5, other general-purpose components may be further included in the circuit 500.

According to an embodiment, the processor 420 may obtain the value of the current of the first input terminal through the first current sensor 520. In some embodiments, the processor 420 may obtain the value of the current of the first stage of the autotransformer 540 through the second current sensor 530.

The processor 420 may predict whether the plurality of loads 550 are unbalanced, based on the value of the current of the first input terminal, the value of the current of the first stage, and a characteristic of the autotransformer 540.

In detail, the processor 420 may predict a value of a first load current, based on the value of the current of the first input terminal and the value of the current of the first stage. Then, the processor 420 may predict a value of a second load current, based on the predicted value of the first load current and a value of a current of a third stage of the autotransformer 540. Next, the processor 420 may compare the predicted value of the first load current and the predicted value of the second load current to predict whether there is an imbalance.

The processor 420 may prevent damage to the plurality of loads 550 connected to the circuit 500 by opening the relay 510 when it is predicted that the current flowing through the plurality of loads 550 is unbalanced and a current equal to or greater than a threshold value flows through the autotransformer 540.

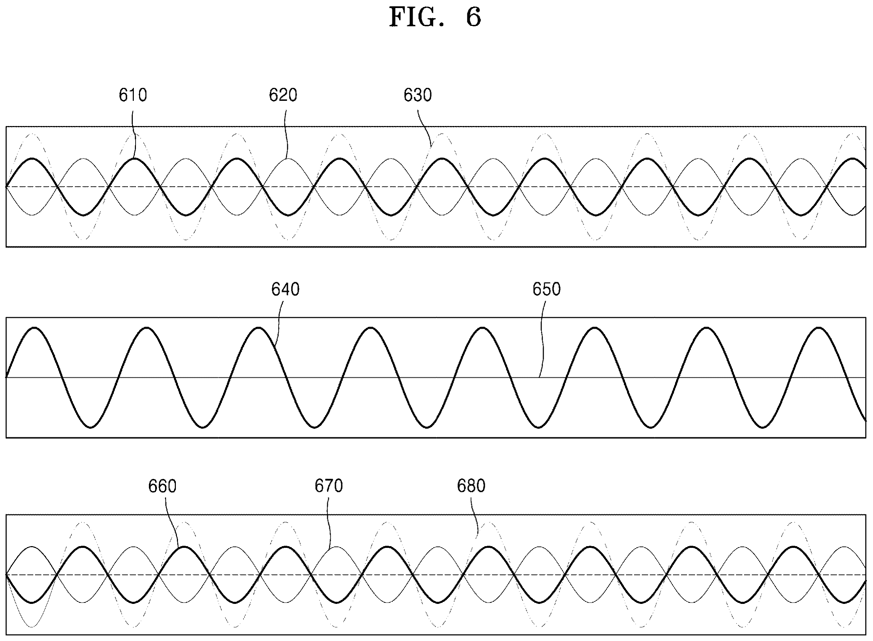

FIG. 6 is a diagram for describing current and voltage waveforms in an unbalanced current, according to an embodiment.

Referring to FIG. 6, the current and voltage waveforms at each node in case of an unbalanced current are illustrated.

In the disclosure, because an autotransformer maintains a voltage applied to a load constant, amplitudes of a first voltage 610 and a second voltage 620 have a same value. Here, a combined value of the amplitudes of the first voltage 610 and the second voltage 620 is the same as an amplitude of a third voltage 630.

According to an embodiment, as shown in FIG. 6, when a current 640 of 30 A flows through a first load and a current 650 of 0 A flows through a second load, an unbalanced current may be determined. In addition, when a value of the current 640 flowing through the first load and a value of the current 650 flowing through the second load are not the same, it may be determined that currents of loads are unbalanced.

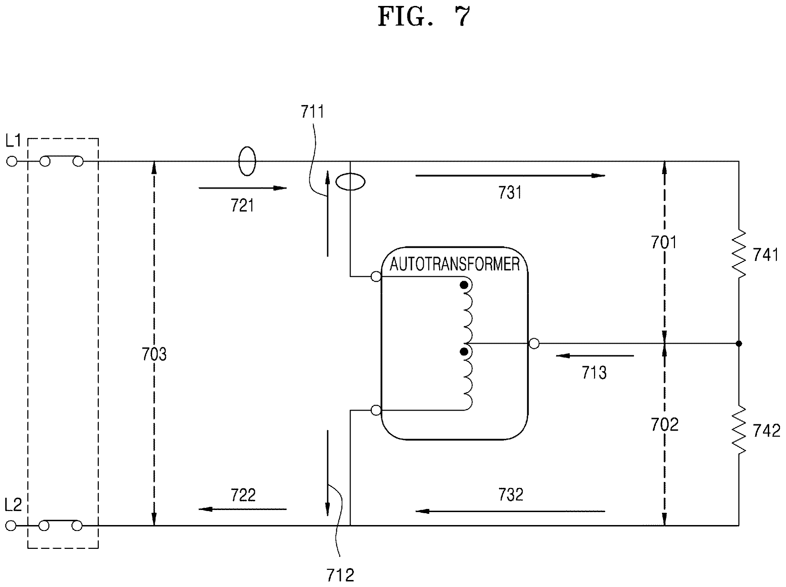

In a situation of an unbalanced current, a value of a current 660 of a first stage, a value of a current 670 of a second stage, and a value of a current 680 of a third stage of the autotransformer may exceed a threshold value of the autotransformer, and in this case, the processor 420 may determine to open the relay 411. A more specific process in which the processor 420 opens the relay 411 will be described below with reference to FIG. 7.

FIG. 7 is a diagram for describing a process of predicting a current of a load in an unbalanced current, according to an embodiment.

Referring to FIG. 7, a current 721 of a first input terminal, a current 722 of a second input terminal, a current 711 of a first stage of an autotransformer, a current 712 of a second stage of the autotransformer, a current 713 of a third stage of the autotransformer, a first load current 731, a first load 741, a second load current 732, a second load 742, a first voltage 701, a second voltage 702, and a third voltage 703 are illustrated.

According to an embodiment, the processor 420 may determine whether a load is unbalanced by using only a value of the current 721 of the first input terminal and a value of the current 711 of the first stage of the autotransformer, which are obtained through a first current sensor and a second current sensor.

In detail, a value of the current 713 of the third stage may be the sum of the value of the current 711 of the first stage and the value of the current 712 of the second stage. In some embodiments, the value of the current 711 of the first stage and the value of the current 712 of the second stage have a same value because a turn ratio of the autotransformer is 1.

For example, when the value of the current 711 of the first stage is 15 A, the processor 420 may predict the value of the current 712 of the second stage as 15 A, and the value of the current 713 of the third stage as 30 A, which is the sum of the value of the current 711 of the first stage and the value of the current 712 of the second stage.

Then, the processor 420 may predict the sum of a value of the current 721 of the first input terminal and the value of the current 711 of the first stage as a value of the first load current 731.

For example, when the value of the current 721 of the first input terminal is 15 A and the value of the current 711 of the first stage is 15 A, the processor 420 may predict the value of the first load current 731 as 30 A.

Next, the processor 420 may predict a value of the second load current 732 by subtracting the value of the current 713 of the third stage from the predicted value of the first load current 731.

For example, the processor 420 may predict the value of the second load current 732 as 0 A, which is a value obtained by subtracting 30 A, which is the value of the current 713 of the third stage, from 30 A, which is the value of the first load current 731.

Next, the processor 420 may compare the predicted value of the first load current 731 and the predicted value of the second load current 732 to predict whether there is an imbalance. In detail, the processor 420 may predict that there is an imbalance when the predicted value of the first load current 731 and the predicted value of the second load current 732 are different from each other.

For example, the processor 420 may predicted that there is an imbalance because the value of the first load current 731 is 30 A and the value of the second load current 732 is 0 A, which are different from each other.

Then, the processor 420 may determine to open a relay when values of currents respectively flowing through a plurality of loads are not the same and a value of a current flowing through the autotransformer is equal to or greater than a threshold value. The processor 420 may prevent damage to a plurality of loads connected to a circuit by opening the relay.

Here, the "threshold value" may indicate a value of an allowable current of the autotransformer, and indicate a maximum value of a current that may be safely processed by a wiring of the autotransformer. Because the threshold value is determined based on a characteristic of the autotransformer, the threshold value may vary depending on a type of the autotransformer.

Even when an unbalanced current flows through the plurality of loads at this time, the first voltage 701 and the second voltage 702 may be maintained constant according to the characteristic of the autotransformer. For example, when the third voltage 703 is 240 V, the first voltage 701 and the second voltage 702 each have a value of 120 V.

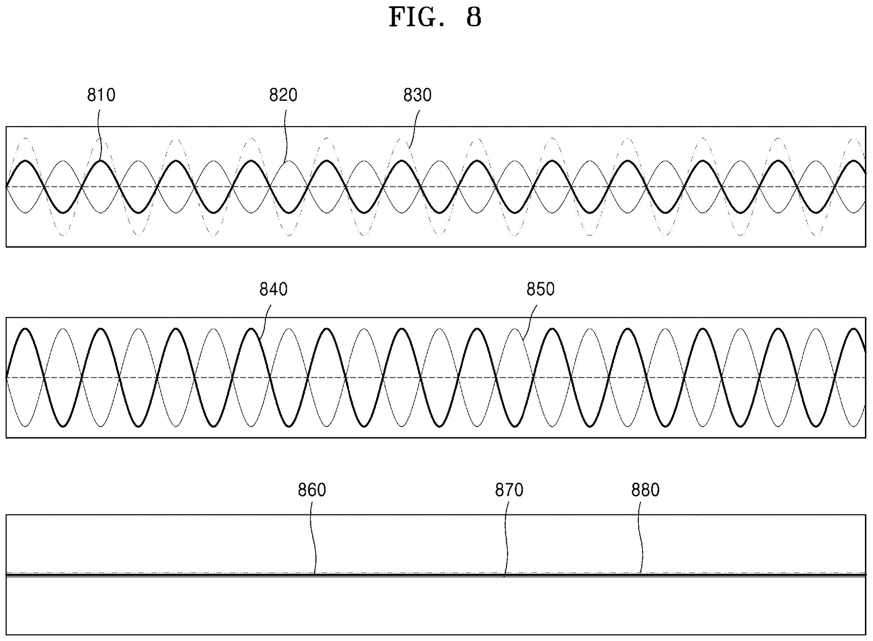

FIG. 8 is a diagram for describing current and voltage waveforms in a balanced current, according to an embodiment.

Referring to FIG. 8, the current and voltage waveforms at each node in case of a balanced current are illustrated.

In the disclosure, because an autotransformer maintains a voltage applied to a load constant, amplitudes of a first voltage 810 and a second voltage 820 have a same value. Here, a combined value of the amplitudes of the first voltage 810 and the second voltage 820 is the same as an amplitude of a third voltage 830.

According to an embodiment, as shown in FIG. 8, when a current 840 of 15 A flows through a first load and a current 850 of 15 A flows through a second load, a balanced current may be determined. In other words, when a value of the current 840 flowing through the first load and a value of the current 850 flowing through the second load are the same, the balanced current may be determined.

In a situation of a balanced current, a value of a current 860 of a first stage, a value of a current 870 of a second stage, and a value of a current 880 of a third stage of an autotransformer may all be 0 A. Accordingly, in the situation of the balanced current, the processor 420 may not need to open a relay because no current equal to or greater than a threshold value flows through the autotransformer.

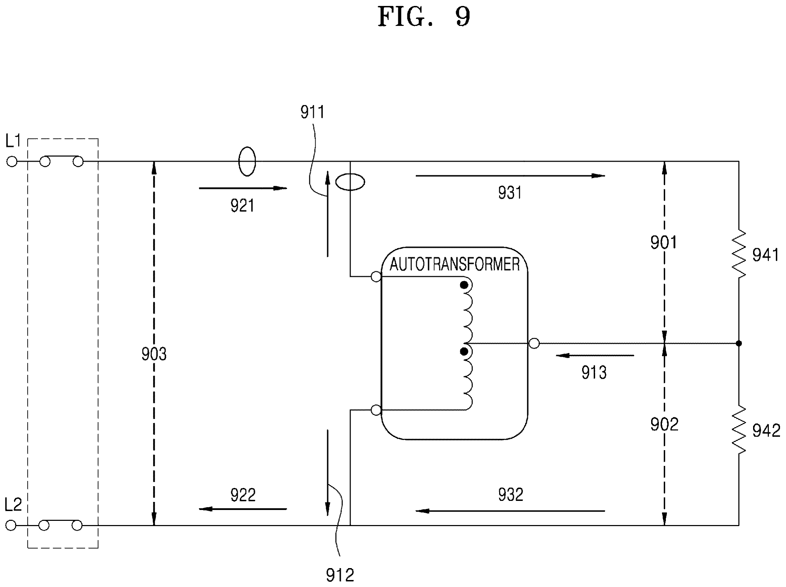

FIG. 9 is a diagram for describing a process of predicting a current of a load in a balanced current, according to an embodiment.

A current 921 of a first input terminal, a current 922 of a second input terminal, a current 911 of a first stage of an autotransformer, a current 912 of a second stage of the autotransformer, a current 913 of a third stage of the autotransformer, a first load current 931, a first load 941, a second load current 932, a second load 942, a first voltage 901, a second voltage 902, and a third voltage 903 are illustrated.

According to an embodiment, the processor 420 may determine whether a load is unbalanced by using only a value of the current 921 of the first input terminal and a value of the current 911 of the first stage of the autotransformer, which are obtained through a first current sensor and a second current sensor.

In detail, a value of the current 913 of the third stage may be the sum of the value of the current 911 of the first stage and the value of the current 912 of the second stage of the autotransformer. In some embodiments, the value of the current 911 of the first stage and the value of the current 912 of the second stage have a same value because a turn ratio of the autotransformer is 1.

For example, when a value of the current 911 of the first stage is 0 A, the processor 420 may predict the value of the current 912 of the second stage as 0 A and the value of the current 913 of the third stage as 0A.

Then, the processor 420 may predict the sum of a value of the current 921 of the first input terminal and the value of the current 911 of the first stage as a value of the first load current 931.

For example, when the value of the current 921 of the first input terminal is 15 A and the value of the current 911 of the first stage is 0 A, the processor 420 may predict the value of the first load current 931 as 15 A.

Next, the processor 420 may predict a value of the second load current 932 by subtracting the value of the current 913 of the third stage from the predicted value of the first load current 931.

For example, the processor 420 may predict the value of the second load current 932 as 15 A, which is a value obtained by subtracting 0 A, which is the value of the current 913 of the third stage, from 15 A, which is the value of the first load current 931.

Next, the processor 420 may compare the predicted value of the first load current 931 and the predicted value of the second load current 932 to predict whether there is an imbalance. In detail, the processor 420 may predict that there is a balance when the value of the first load current 931 and the value of the second load current 932 are the same.

For example, the processor 420 may predict that there is a balanced current because the value of the first load current 931 and the value of the second load current 932 are the same, i.e., 15 A. In a case of the balanced current, the processor 420 may not open a relay because the value of the current 911 of the first stage and the value of the current 912 of the second stage, which are values of currents flowing through the autotransformer, are both 0 A and do not exceed the threshold value.

Additionally, depending on the characteristic of the autotransformer, the first voltage 901 and the second voltage 902 may be maintained constant. For example, when the third voltage 903 is 240 V, the first voltage 901 and the second voltage 902 each have a value of 120 V.

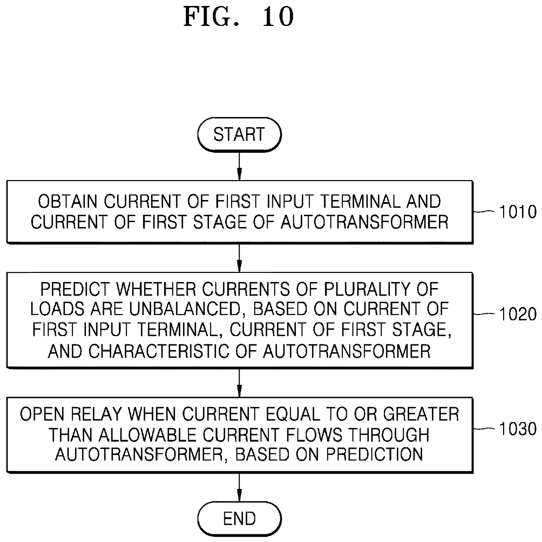

FIG. 10 is a flowchart of a method of predicting a current of a load in an autotransformer, according to an embodiment.

Referring to FIG. 10, in operation 1010, a processor may obtain a value of a current of a first input terminal and a value of a current of a first stage of an autotransformer, through a first current sensor and a second current sensor.

In operation 1020, the processor may predict whether a plurality of loads are unbalanced, based on a value of the current of the first input terminal, a value of the current of the first stage, and a characteristic of the autotransformer.

Here, the characteristic of the autotransformer may include a turn ratio of 1.

In operation 1030, the processor may determine whether to open a relay, based on a result of the prediction and a current flowing through the autotransformer.

In detail, the processor may determine to open the relay when it is predicted that the currents flowing through the plurality of loads are unbalanced and a current equal to or greater than a threshold value flows through the autotransformer. The processor may prevent damage to the plurality of loads connected to a circuit by opening the relay.

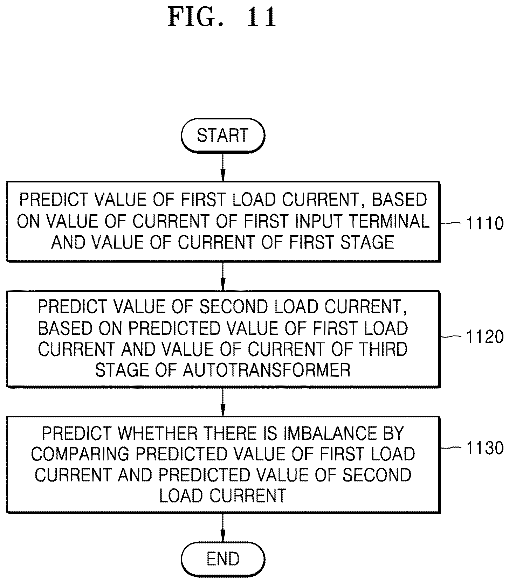

FIG. 11 is a flowchart for describing a process of predicting imbalance when an unbalanced current flows in a load, according to an embodiment.

In operation 1110, a processor may predict a value of a first load current, based on a value of a current of a first input terminal and a value of a current of a first stage.

In detail, the processor may predict a sum of the value of the current of the first input terminal and the value of the current of the first stage as the value of the first load current.

In operation 1120, the processor may predict a value of a second load current, based on the predicted value of the first load current and a value of a current of a third stage of an autotransformer.

In detail, the processor may predict a sum of the value of the current of the first stage and a value of a current of a second stage as the value of the current of the third stage. In some embodiments, the processor may predict the value of the second load current by subtracting the value of the current of the third stage from the predicted value of the first load current.

In operation 1130, the processor may compare the predicted value of the first load current and the predicted value of the second load current to predict whether there is an imbalance.

In detail, the processor may predict that there is an imbalance when the predicted value of the first load current and the predicted value of the second load current are different from each other.

According to an embodiment of the disclosure, unbalanced currents of all loads may be predicted by measuring only a single current in an autotransformer, and protection from an overcurrent may be provided by opening a relay, thereby preventing damage to a circuit and a component.

The above-described apparatus may also be implemented as computer-readable code on a computer-readable recording medium. The computer-readable recording medium may include any type of recording apparatus storing data capable of being read by a computer system. Examples of the computer-readable recording medium include read-only memory (ROM), random-access memory (RAM), CD-ROM, a magnetic tape, a floppy disk, and an optical data storage device. The computer-readable recording medium may be distributed over the computer system connected through a network, and computer-readable code may be stored and executed in a distributed manner. In addition, functional programs, codes, and code segments for implementing the embodiments may be easily inferred by programmers of ordinary skill in the art to which the disclosure belongs.

Techniques described herein may be implemented by various means. For example, these techniques may be implemented as hardware, firmware, software, or a combination thereof. One of ordinary skill in the art will further understand that various illustrative logical blocks, models, circuits, and algorithm steps described in connection with the disclosure may be implemented as electronic hardware, computer software, or a combination thereof. To clearly describe such interchangeability of hardware and software, various illustrative components, blocks, models, circuits, and steps have been described above generally in terms of their functionality. Whether such functionality is implemented as hardware or software depends on design constraints applied to a specific application or an entire system. One of ordinary skill in the art may implement the above-described functionality in various ways for each specific application, but such implementation determinations should not be interpreted as departing from the scope of the disclosure.

In hardware implementation, processing units used to perform the techniques may be implemented within one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform function described herein, a computer, or a combination thereof.

Accordingly, various logic blocks, models, and circuits described in connection with the disclosure herein may be implemented or performed by any combination of a general-purpose processor, a DSP, an ASIC, an FPGA or another programmable logic device, discrete gate or transistor logic, discrete hardware components, or those designed to perform the functions described herein. The general-purpose processor may be a microprocessor, but alternatively, the processor may be any processor of the related art, a controller, a microcontroller, or a state machine. The processor may also be implemented as a combination of computing devices, for example, a DSP and a microprocessor, a plurality of microprocessors, one or more microprocessors in association with a DSP core, or any other such configuration.

In firmware and/or software implementation, the techniques may be implemented as instructions stored in a computer-readable medium, such as RAM, ROM, non-volatile (NVRAM), programmable (PROM), erasable programmable (EPROM), electrically erasable PROM (EEPROM), a flash memory, a compact disc (CD), a magnetic or optical data storage device, or the like. The instructions may be executable by one or more processors and may cause the processor(s) to perform particular aspects of the functionality described herein.

When implemented as software, the functionalities may be stored in or transmitted through a computer-readable medium, as one or more instructions or codes. Computer-readable media includes any medium that facilitates transmission of a computer program from one place to another place, and includes both a computer storage medium and a communication medium. Storage media may be any available media that may be accessed by a computer. As unlimited examples, such computer-readable media may include RAM, ROM, EEPROM, CD-ROM or another optical disk storage, magnetic disk storage or another magnetic storage device, or any other medium that may be used to carry or store desired program code in the form of instructions or data structures and that may be accessed by a computer. Any connection is properly referred to as a computer-readable medium.

For example, when software is transmitted from a website, a server, or another remote source by using a coaxial cable, a fiber optic cable, a twisted cable, a digital subscriber line (DSL), or wireless technologies such as infrared, radio, and microwaves, the coaxial cable, the fiber optic cable, the twisted cable, the DSL, or the wireless technologies such as infrared, radio, and microwaves are included in the definition of media. A disk and a disc as used herein include CDs, laser discs, optical discs, digital versatile discs (DVDs), floppy disks, and Blu-ray discs, wherein disks usually reproduce data magnetically, whereas discs reproduce data optically using lasers. Combinations thereof should also be included within the scope of computer-readable media.

A software model may be stored in RAM, a flash memory, ROM, EPROM, EEPROM, a register, a hard disk, a removable disk, CD-ROM, or any other form of storage medium known in the art. An exemplary storage medium may be coupled to a processor such that the processor may read information from the storage medium or write information on the storage medium. Alternatively, the storage medium may be integrated into the processor. The processor and the storage medium may be present within ASIC. ASIC may be present in a user terminal. Alternatively, the processor and the storage medium may be present as separate components in the user terminal.

The above descriptions of the disclosure are provided to enable one of ordinary skill in the art to execute or use the disclosure. Various modifications to the disclosure will be readily apparent to one of ordinary skill in the art, and general principles defined herein may be applied to the various modifications without departing from the spirit or scope of the disclosure. Accordingly, the disclosure is not intended to be limited to embodiments described herein but is to be accorded the widest scope consistent with the principles and novel features disclosed herein.

Although the subject matter has been described in language specific to structural features and/or methodological acts, it is to be understood that the subject matter defined in the appended claims is not necessarily limited to the specific features or acts described above. Rather, the specific features and acts described above are described as exemplary forms of implementing the claims.

Although the method described in this specification has been described through specific embodiments, it is possible to implement the method as computer-readable code on a computer-readable recording medium. The computer-readable recording medium may include any type of recording apparatus storing data capable of being read by a computer system. Examples of the computer-readable recording medium include ROM, RAM, CD-ROM, a magnetic tape, a floppy disk, and an optical data storage device. The computer-readable recording medium may be distributed over the computer system connected through a network, and computer-readable code may be stored and executed in a distributed manner. In addition, functional programs, codes, and code segments for implementing the embodiments may be easily inferred by programmers of ordinary skill in the art to which the disclosure belongs.

Although the disclosure has been described in connection with certain embodiments herein, various modifications and changes may be made without departing from the scope of the disclosure, which may be understood by one of ordinary skill in the art. Such modifications and changes should be considered to fall within the scope of the claims appended to the present specification.

## Claims

1. A method of predicting a current of a load in an autotransformer, the method comprising:
obtaining a value of a current of a first input terminal and a value of a current of a first stage of the autotransformer;
predicting whether a plurality of loads are unbalanced, based on the value of the current of the first input terminal, the value of the current of the first stage, and a characteristic of the autotransformer; and
determining whether to open a relay, based on a result of the prediction and a current flowing through the autotransformer,
wherein a turn ratio of the autotransformer is 1.

2. The method of claim 1, wherein the determining comprises, when values of currents respectively flowing through the plurality of loads are not same according to the result of the prediction and a value of the current flowing through the autotransformer is equal to or greater than a threshold value, determining to open the relay.

3. The method of claim 1, wherein the obtaining comprises obtaining the value of the current of the first input terminal through a first current sensor.

4. The method of claim 1, wherein the obtaining comprises obtaining the value of the current of the first stage through a second current sensor.

5. The method of claim 1, wherein the predicting comprises:
predicting a value of a first load current, based on the value of the current of the first input terminal and the value of the current of the first stage;
predicting a value of a second load current, based on the predicted value of the first load current and a value of a current of a third stage of the autotransformer; and
comparing the predicted value of the first load current and the predicted value of the second load current to predict whether the plurality of loads are unbalanced.

6. The method of claim 5, wherein the predicting comprises predicting that the plurality of loads are balanced when the value of the first load current and the value of the second load current are the same, and predicting that the plurality of loads are unbalanced when the value of the first load current and the value of the second load current are different from each other.

7. The method of claim 5, wherein the value of the current of the third stage includes a sum of the value of the current of the first stage and a value of a current of a second stage of the autotransformer, and
the value of the current of the first stage and the value of the current of the second stage are the same.

8. A processor configured to:
obtain a value of a current of a first input terminal and a value of a current of a first stage of an autotransformer;
predict whether a plurality of loads are unbalanced, based on the value of the current of the first input terminal, the value of the current of the first stage, and a characteristic of the autotransformer; and
determine whether to open a relay, based on a result of the prediction and a current flowing through the autotransformer,
wherein a turn ratio of the autotransformer is 1.

9. The processor of claim 8, further configured to, when values of currents respectively flowing through the plurality of loads are not same according to the result of the prediction and a value of the current flowing through the autotransformer is equal to or greater than a threshold value, determine to open the relay.

10. The processor of claim 8, further configured to obtain the value of the current of the first stage through a second current sensor.

11. The processor of claim 8, further configured to predict a value of a first load current, based on the value of the current of the first input terminal and the value of the current of the first stage, predict a value of a second load current, based on the predicted value of the first load current and a value of a current of a third stage of the autotransformer, and compare the predicted value of the first load current and the predicted value of the second load current to predict whether the plurality of loads are unbalanced.

12. The processor of claim 11, further configured to predict that the plurality of loads are balanced when the value of the first load current and the value of the second load current are the same, and predict that the plurality of loads are unbalanced when the value of the first load current and the value of the second load current are different from each other.

13. The processor of claim 11, wherein the value of the current of the third stage includes a sum of the value of the current of the first stage and a value of a current of a second stage of the autotransformer, and
the value of the current of the first stage and the value of the current of the second stage are the same.

14. The processor of claim 8, wherein the processor is included in a distribution device of a solar power generation system.

15. A computer-readable recording medium having recorded thereon a program for causing a computer to execute the method of claim 1.
